Europäisches Patentamt

European Patent Office

Office européen des brevets

(19)

(11) Numéro de publication: **0 059 133**
**B1**

(12) **FASCICULE DE BREVET EUROPEEN**

(45) Date de publication du fascicule du brevet:
**24.07.85**

(51) Int. Cl.⁴: **H 04 N 11/18, H 03 H 17/04**

(21) Numéro de dépôt: **82400207.5**

(22) Date de dépôt: **05.02.82**

(54) **Filtre de désaccentuation du signal de chrominance, et récepteur de télévision comportant un tel filtre.**

(30) Priorité: **24.02.81 FR 8103624**

(43) Date de publication de la demande:
**01.09.82 Bulletin 82/35**

(45) Mention de la délivrance du brevet:
**24.07.85 Bulletin 85/30**

(84) Etats contractants désignés:
**DE**

(56) Documents cités:
**FR - A - 2 412 216**
**US - A - 3 843 940**

**R.E. BOGNER et al. "INTRODUCTION TO DIGITAL FILTERING", 1975 JOHN WELEY & SONS LONDRES (GB)**
**Introduction to Digital Filters, Trevor J. TERREL, page 136**

(73) Titulaire: **SOCIETE D'ELECTRONIQUE DE LA REGION PAYS de LOIRE - SEREL, 74, rue du Surmelin, F-75020 Paris (FR)**

(72) Inventeur: **Dutasta, Rémy, THOMSON-CSF SCPI 173, bld Haussmann, F-75360 Paris Cedex 08 (FR)**

(74) Mandataire: **Boireau, Jacques et al, Thomson-CSF SCPI 173, boulevard Haussmann, F-75379 Paris Cedex 08 (FR)**

ACTORUM AG

## Description

L'invention est relative à un filtre passe-bas, notamment un filtre de désaccentuation du signal de chrominance pour un récepteur de télévision, ainsi qu'à un récepteur de télévision comportant un tel filtre.

On sait que dans le procédé SECAM de télévision pour améliorer le rapport signal sur bruit — c'est-à-dire pour diminuer le bruit — le signal de télévision est préaccentué dans les aigues à l'émission et est complémentairement désaccentué à la réception. Pour cette désaccentuation on utilise un filtre passe-bas appelé filtre de désaccentuation.

Par ailleurs on connaît l'avantage présenté par la transmission sous forme numérique, ou échantillonnée dans le temps, de signaux par rapport à la transmission sous forme analogique, notamment en ce qui concerne la précision, la sensibilité au bruit et les dérives dues aux variations de caractéristiques de composants. Mais l'application de la technique numérique à la télévision est particulièrement difficile en raison des valeurs élevées des fréquences des signaux et du fonctionnement en «temps réel», c'est-à-dire de la simultanéité du traitement du signal avec l'émission.

Cependant, l'utilisation d'un filtrage numérique en vue de la désaccentuation de signaux de télévision en couleurs est déjà connue par le Brevet US-3 843 940.

L'invention permet de minimiser le coût de réalisation du filtre et de minimiser les retards qu'il introduit.

Le filtre passe-bas numérique pour la désaccentuation du signal de chrominance dans un récepteur de télévision SECAM est selon l'invention, caractérisé en ce qu'il présente une fonction de transfert en z de la forme suivante:

$$T(z) = \frac{a + bz^{-1}}{c + dz^{-1}} \qquad (1)$$

a, b, c et d étant des constantes, et en ce qu'il comprend des éléments agencés de façon telle qu'ils font intervenir à la sortie de l'un d'entre eux la fonction intermédiaire:

$$U(z) = \frac{X(z)}{1 + \frac{d}{c}z^{-1}}$$

X(z) étant la transformée en z du signal à l'entrée du filtre, ces éléments comportant un premier additionneur dont une entrée reçoit le signal X et dont une seconde entrée reçoit le signal de sortie d'un élément de retard par l'intermédiaire d'un multiplicateur par $-\frac{d}{c}$ l'entrée de l'élément de retard étant connectée à la sortie dudit premier additionneur, et un second additionneur à deux entrées dont la première est reliée à la sortie de l'élément de retard par l'intermédiaire d'un multiplicateur par $\frac{b}{a}$ et dont la seconde entrée est reliée à la sortie du premier additionneur.

Pour plus de détail sur les techniques mathématiques utilisées pour le calcul et la conception des filtres numériques et sur des réalisations de tels filtres on pourra se reporter par exemple à l'ouvrage de Andreas Antoniou intitulé «Digital filters analysis and design» (filtres numériques : analyse et conception) des Editions Mac Graw Hill.

D'autres caractéristiques de l'invention apparaîtront avec la description de certains de ses modes de réalisation, celle-ci étant effectuée en se référant aux dessins ci-annexés sur lesquels:

- La figure 1 est un schéma d'un filtre connu,
- La figure 2 est un graphique représentant les variations, en fonction de la pulsation ω, de l'affaiblissement du filtre de la figure 1,
- La figure 3 est un schéma d'un filtre selon l'invention et,
- La figure 4 est un schéma d'une autre réalisation de filtre selon l'invention.

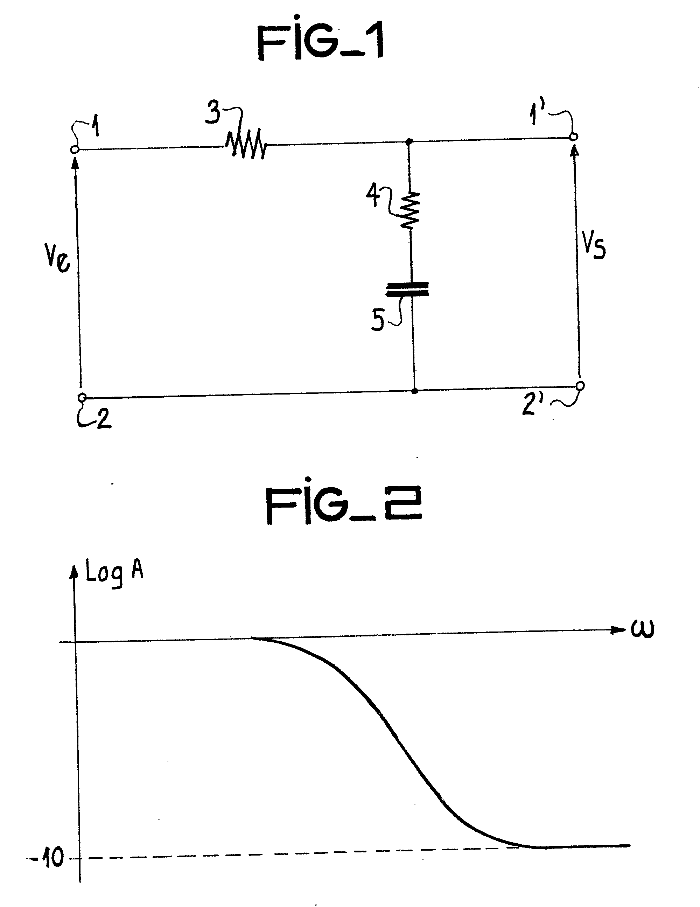

Un filtre connu de désaccentuation du signal de chrominance dans un récepteur de télévision SECAM du type analogique (Brevet français 2 412 216) comprend (fig. 1) deux bornes d'entrée 1 et 2 et deux bornes de sortie 1' et 2', la borne 2' étant reliée directement à la borne 2. Entre les bornes 1 et 1' est disposée une première résistance 3 de valeur $R_1$, et entre les bornes 1' et 2' se trouve une seconde résistance 4 de valeur $R_2$ en série avec un condensateur 5 de capacité C.

La figure 2 montre la courbe de réponse de ce filtre, la pulsation du signal d'entrée étant portée en abscisses; en ordonnées on a porté le logarithme, exprimé en décibels, de l'affaiblissement A du filtre, c'est-à-dire:

$$\text{Log } A = \text{Log}\left(\frac{Vs}{Ve}\right) \qquad (2)$$

Dans cette formule Vs représente la tension de sortie et Ve la tension d'entrée (figure 1).

Le calcul montre que la fonction de transfert du filtre de la figure 1 est la suivante:

$$\frac{V_s}{V_e} = \frac{1 + \dfrac{j\omega}{\omega_c}}{1 + jn\dfrac{\omega}{\omega_c}} \qquad (3)$$

Dans cette formule:

$$\omega_c = \frac{1}{R_2 C}, \text{ et} \qquad (4)$$

$$n = \frac{R_1 + R_2}{R_2} \qquad (5)$$

Pour obtenir la fonction de transfert en z d'un filtre numérique ayant la même courbe de réponse que ce filtre analogique on remplace la variable jω par la variable $\frac{z-1}{z+1}$ (cette transformation s'appelle transformation en z du type homographique) et on obtient la fonction de transfert en Z suivante:

$$T(z) = \frac{a + bz^{-1}}{c + dz^{-1}} = \frac{Y(z)}{X(z)} \qquad (6)$$

Dans cette formule Y(z) est la tension à la sortie du filtre numérique tandis que X(z) est la tension à l'entrée de ce filtre numérique.

La formule ci-dessus peut s'écrire encore de la façon suivante:

$$K \cdot Y(z) = \frac{1 + \frac{b}{a} z^{-1}}{1 + \frac{d}{c} z^{-1}} \cdot X(z) \qquad (7)$$

$$\text{Avec } K = \frac{c}{a}$$

Cette formule peut encore être transformée comme suit:

$$K \cdot Y(z) = S(z) = (1 + \frac{b}{a} z^{-1}) \, U(z) \qquad (8),$$

$$\text{avec } U(z) = \frac{X(z)}{1 + \frac{d}{c} z^{-1}} \qquad (9),$$

$$\text{d'où on déduit: } U(z) = X(z) - \frac{d}{c} U(z) \cdot z^{-1}. \qquad (10)$$

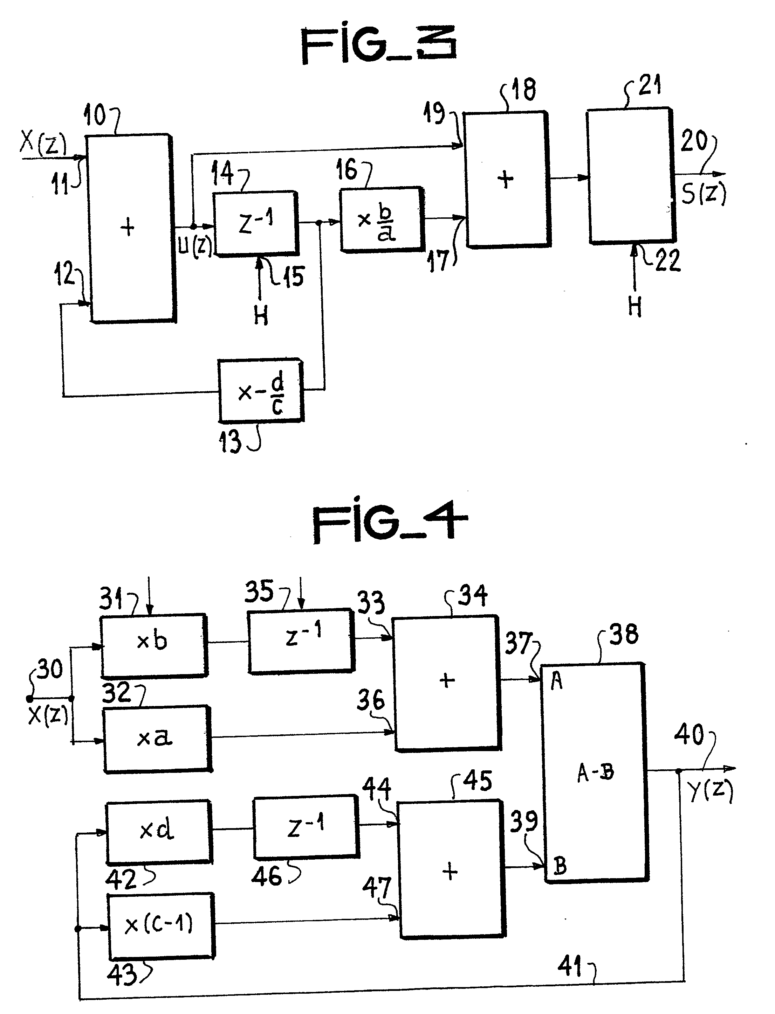

Les formules (8) et (10) conduisent à réaliser le filtre numérique conformément au schéma de la figure 3.

Dans cette réalisation le filtre comprend un additionneur binaire 10 à deux entrées 11 et 12 dont la première reçoit le signal d'entrée X et dont la seconde est connectée à la sortie d'un multiplicateur 13 par le coefficient $-\frac{d}{c}$.

La sortie de l'additionneur 10 est reliée à l'entrée d'un élément de retard 14 représentant la fonction $z^{-1}$ et sur une entrée 15 duquel est appliqué un signal d'horloge H à la fréquence d'échantillonnage qui est égale, dans l'exemple, à 4286 KHz. La sortie de l'élément de retard 14 est reliée à l'entrée du multiplicateur 13 ainsi qu'à l'entrée d'un autre multiplicateur 16 qui effectue la multiplication par un coefficient égal à $\frac{b}{a}$. La sortie du multiplicateur 16 est reliée à la seconde entrée 17 d'un autre additionneur 18 dont la première entrée 19 est connectée à la sortie du premier additionneur 10.

La sortie de l'additionneur 18 est connectée à la sortie 20 du filtre par l'intermédiaire d'un registre 21 présentant une entrée 22 pour le signal d'horloge H.

On peut vérifier aisément que ce filtre réalise les fonctions définies par les formules (8) et (10). La fonction U(z) est obtenue à la sortie de l'additionneur 10. A la sortie de l'élément de retard 14 on obtient la fonction $U(z) \cdot z^{-1}$. A la sortie du registre 21 apparaît la fonction $S(z) = K \cdot Y(z)$.

Dans l'exemple les divers éléments (additionneurs, retard et multiplicateurs) du filtre sont réalisés en technologie bipolaire du type TTL dont la rapidité de fonctionnement est satisfaisante pour l'application envisagée. Chacun des multiplicateurs, 13, 16, est constitué par une mémoire morte programmable (PROM). L'élément de retard 14 comporte des bascules bistables du type D.

L'ensemble des éléments du filtre peut également faire partie d'un unique circuit intégré. Dans ce cas il est avantageux de constituer les multiplicateurs 13 et 16 par des mémoires mortes programmables (PROM) éventuellement effaçables aux rayons ultraviolets (UV PROM) et dont le contenu peut être modifié à volonté de l'extérieur.

Dans une réalisation particulière, pour laquelle la fréquence d'échantillonnage est de 4286 KHz, le coefficient $\frac{b}{a}$ a la valeur $-0,685$ et le coefficient $\frac{d}{c}$ la valeur $-0,8827$.

Le calcul montre que si le signal X à l'entrée 11 du filtre est un signal binaire à 7 bits, le signal sur la seconde entrée 12 de l'additionneur 10 devrait être à 10 bits, le signal de sortie U(z) de l'additionneur 10 sera aussi à 10 bits, de même que le signal $U(z) \cdot z^{-1}$ à la sortie de l'élément de retard 14. Le signal sur l'entrée 17 de l'additionneur 18 est à 9 bits tandis que le signal de sortie de cet additionneur est à 8 bits de même que le signal de sortie S(z) du filtre.

Le filtre représenté sur la figure 4 est, comme celui décrit en relation avec la figure 3, constitué de multiplicateurs par des coefficients constants, d'éléments de retard, d'additionneurs et, en outre, d'un soustracteur. Son architecture se déduit de la formule (6) de fonction de transfert en z.

L'entrée 30 de ce filtre sur laquelle est appliquée un signal X(z) est reliée d'une part à l'entrée d'un multiplicateur 31 par le coefficient b et d'autre part à l'entrée d'un multiplicateur 32 par le coefficient a. La sortie du multiplicateur 31 est reliée à la première entrée 33 d'un additionneur 34 par l'intermédiaire d'un élément de retard 35 effectuant l'opération $z^{-1}$.

La seconde entrée 36 de l'additionneur 34 reçoit le signal fourni par le multiplicateur 32. La sortie dudit additionneur 34 est reliée à la première entrée 37 d'un soustracteur 38 qui effectue la soustraction A–B entre le signal A appliqué sur son entrée 37 et le signal B appliqué sur sa seconde entrée 39. C'est la sortie du soustracteur 38 qui constitue la sortie 40 du filtre sur laquelle apparaît le signal Y(z).

Cette sortie 40 est reliée, par une connexion 41, d'une part à l'entrée d'un multiplicateur 42 par le coefficient d et d'autre part à l'entrée d'un autre multiplicateur 43 par le coefficient c−1. La sortie du multiplicateur 42 est reliée à la première entrée 44 d'un additionneur 45 par l'intermédiaire d'un élément de retard 46, La seconde entrée 47 de l'additionneur 45 reçoit le signal de sortie du multiplicateur 43. La sortie dudit additionneur 45 est reliée à la seconde entrée 39 du soustracteur 38.

On peut aisément vérifier que l'architecture de ce filtre permet de réaliser la fonction de transfert en Z définie ci-dessus par la formule (6).

Pour la plupart des applications on préférera la réalisation représentée sur la figure 3 à celle représentée sur la figure 4 car cette dernière fait appel à un nombre supérieur d'éléments et entraîne des retards plus importants.

Le filtre selon l'invention peut être utilisé non seulement pour effectuer la désaccentuation du signal de chrominance dans le procédé SECAM de télévision mais également, de façon plus générale, pour constituer un filtre numérique passe-bas par exemple dans une chaîne de traitement numérique du son.

**Revendications**

1. Filtre passe-bas numérique pour la désaccentuation du signal de chrominance dans un récepteur de télévision SECAM, caractérisé en ce qu'il présente une fonction de transfert en z de la forme suivante:

$$T(z) = \frac{a + bz^{-1}}{c + dz^{-1}}$$

a, b, c et d étant des constantes, et en ce qu'il comprend des éléments agencés de façon telle qu'ils font intervenir à la sortie de l'un d'entre eux la fonction intermédiaire:

$$U(z) = \frac{X(z)}{1 + \dfrac{d}{c} z^{-1}}$$

X(z) étant la transformée en z du signal à l'entrée du filtre, ces éléments comportant un premier additionneur (10) dont une entrée (11) reçoit le signal X et dont une seconde entrée (12) reçoit le signal de sortie d'un élément de retard (14) par l'intermédiaire d'un multiplicateur (13) par $-\dfrac{d}{c}$, l'entrée de l'élément de retard étant connectée à la sortie dudit premier additionneur, et un second additionneur (18) à deux entrées dont la première (17) est reliée à la sortie de l'élément de retard par l'intermédiaire d'un multiplicateur (16) par $\dfrac{b}{a}$ et

dont la seconde entrée (19) est reliée à la sortie du premier additionneur (10).

2. Filtre selon la revendication 1, caractérisé en ce que chaque multiplicateur est constitué d'une mémoire morte programmable éventuellement effaçable aux rayons ultra-violets (PROM ou UV PROM).

3. Filtre selon la revendication 1 ou 2, caractérisé en ce que l'élément de retard comporte des bascules du type D.

4. Filtre passe-bas numérique pour la désaccentuation du signal de chrominance dans un récepteur de télévision SECAM, caractérisé en ce qu'il présente une fonction de transfert en z de la forme suivante:

$$T(z) = \frac{a + bz^{-1}}{c + dz^{-1}}$$

a, b, c et d étant constantes, et en ce qu'il comprend un soustracteur (38) dont les première et seconde entrées (37, 39) sont reliées aux sorties d'additionneurs (34, 45) respectifs et dont la sortie (40) constitue la sortie du filtre, un multiplicateur (31) par b dont la sortie est reliée à une entrée (33) du premier additionneur (34) par l'intermédiaire d'un élément de retard (35), un multiplicateur (32) par a dont la sortie est reliée à la seconde entrée (36) du premier additionneur (34), le signal d'entrée X(z) du filtre étant appliqué à l'entrée de ces multiplicateurs, deux autres multiplicateurs (42, 43) par les coefficients respectivement d et c−1 et dont les entrées sont connectées à la sortie (40) du soustracteur, la sortie du multiplicateur (42) par d étant reliée à une entrée (44) du second additionneur (45) par l'intermédiaire d'un autre élément de retard (46) et la sortie du multiplicateur (43) par c-1 étant reliée à une seconde entrée (47) de ce second additionneur (45).

5. Filtre selon l'une quelconque des revendications précédentes caractérisé en ce que la fréquence d'échantillonnage étant de l'ordre de 4286 KHz le coefficient $\dfrac{b}{a}$ a pour valeur −0,685 et

le coefficient $\dfrac{d}{c}$ pour valeur −0,8827.

6. Récepteur de télévision caractérisé en ce qu'il comporte un filtre selon l'une quelconque des revendications 1 à 5.

**Claims**

1. A digital low-pass filter used to desaccentuate the chrominance signal in a SECAM TV-receiver, characterized in that it presents a z-transfer function according to the following formula:

$$T(z) = \frac{a + bz^{-1}}{c + dz^{-1}}$$

a, b, c and d being constant values, and that it comprises elements which are arranged in such a manner that at the output of one of these elements, the following intermediate function is available:

$$U(z) = \frac{X(z)}{1 + \dfrac{d}{c} z^{-1}}$$

X(z) being the z-transform of the signal at the input of the filter, these elements comprising a first adder (10), one input of which (11) receives the signal X and a second input (12) of which receives the output signal of a delay element (14) via a multiplier (13) having a multiplication factor of $(-d/c)$, the input of the delay element being connected to the output of said first adder, and comprising a second adder (18) having two inputs, the first of which (17) is connected to the output of the delay element via a multiplier (16) having a multiplication factor of (b/a) and the second input (19) of which is connected to the output of the first adder (10).

2. A filter according to claim 1, characterized in that each multiplier is constituted by a programmable read-only-memory which can possibly be erased by an ultraviolet radiation (PROM or UVPROM).

3. A filter according to claim 1 or 2, characterized in that the delay element comprises flip-flops of the D-type.

4. A digital low pass filter used to desaccentuate the chrominance signal in a SECAM TV receiver, characterized in that it presents a z-transfer-function according to the following formula:

$$T(z) = \frac{a + bz^{-1}}{c + dz^{-1}}$$

a, b, c and d being constant values, and that it comprises a subtractor (38), the first and second inputs (37, 39) of which are connected to the outputs of respective adders (34, 45) and the output (40) of which constitutes the output of the filter, comprises moreover a multiplier (31) having a multiplication factor of b, the output of which is connected to one input (33) of a first adder (34) via a delay element (35), comprising moreover a multiplier (32) having a multiplication factor a, the output of which is connected to the second input (36) of the first adder (34), the input signal X(z) of the filter being applied to the input of these multipliers, moreover comprising two further multipliers (42, 43) having multiplication factors of d and (c-1) respectively, the inputs of which are connected to the output (40) of the subtractor, the output of the multiplier (42) having the multiplication factor d being connected to one input (44) of the second adder (45) via a further delay element (46), and the output of the multiplier (43) having a multiplication factor of (c-1) being connected to a second input (47) of this second adder (45).

5. A filter according to any one of the preceding claims, characterized in that, the sampling frequency being about 4286 KHz, the coefficient (b/a) is chosen at $-0,685$ and the coefficient (d/c) is chosen at $-0,8827$.

6. A TV receiver, characterized in that it comprises a filter according to any one of the claims 1 to 5.

**Patentansprüche**

1. Digitales Tiefpassfilter für die Dynamikverringerung des Farbtonsignals in einem SECAM-Fernsehempfänger, dadurch gekennzeichnet, dass es eine z-Transferfunktion der folgenden Form besitzt:

$$T(z) = \frac{a + bz^{-1}}{c + dz^{-1}}$$

wobei a, b, c und d Festwerte sind, und dass es Elemente aufweist, die so angeordnet sind, dass sich am Ausgang eines dieser Elemente die Zwischenfunktion ergibt:

$$U(z) = \frac{X(z)}{1 + \dfrac{d}{c} z^{-1}}$$

wobei X(z) die z-Transformierte des Filtereingangssignals darstellt und diese Elemente einen ersten Addierer (10), dessen einer Eingang (11) das Signal X und dessen anderer Eingang (12) das Ausgangssignal eines Verzögerungselements (14) über einen Multiplizierer (13) mit dem Faktor $(-d/c)$ zugeführt erhält, wobei der Eingang des Verzögerungselements mit dem Ausgang des ersten Addierers verbunden ist, und einen zweiten Addierer (18) mit zwei Eingängen enthalten, dessen erster Eingang (17) mit dem Ausgang des Verzögerungselements über einen Multiplizierer (16) mit dem Faktor (b/a) verbunden ist, während der zweite Eingang (19) des zweiten Addierers (18) mit dem Ausgang des ersten Addierers (10) verbunden ist.

2. Filter nach Anspruch 1, dadurch gekennzeichnet, dass jeder Multiplizierer aus einem programmierbaren und eventuell mit Hilfe von ultravioletten Strahlen löschbaren Festspeicher (PROM oder UVPROM) gebildet wird.

3. Filter nach Anspruch 1 oder 2, dadurch gekennzeichnet, dass das Verzögerungselement Kippstufen vom D-Typ enthält.

4. Digitales Tiefpassfilter für die Dynamikverringerung des Farbtonsignals in einem SECAM-Fernsehempfänger, dadurch gekennzeichnet, dass es eine z-Transferfunktion der folgenden Form aufweist:

$$T(z) = \frac{a + bz^{-1}}{c + dz^{-1}}$$

wobei a, b, c und d Festwerte sind, und dass es einen Subtraktionskreis (38), dessen erster und zweiter Eingang (37, 39) jeweils an den Ausgang eines Addierers (34, 45) angeschlossen sind und dessen Ausgang (40) den Ausgang des Filters bildet, einen Multiplizierer (31) mit dem Faktor d, dessen Ausgang an einen Eingang (33) des ersten Addierers (34) über ein Verzögerungselement (35) angeschlossen ist, einen Multiplizierer (32) mit dem Faktor a, dessen Ausgang an den zweiten Eingang (36) des ersten Addierers (34) angeschlossen ist, wobei das Eingangssignal X(z) des Filters an den Eingang dieser Multiplizierer angeschlossen ist, und zwei weitere Multiplizierer (42, 43) mit den Faktoren d bzw. (c-1) enthält, deren Eingänge an den Ausgang (40) des Subtrahiergliieds angeschlossen sind, wobei der Ausgang des Multiplizierers (42) mit dem Faktor d an einen Eingang (44) des zweiten Addierers (45) über ein weiteres Verzögerungselement (46) und der Ausgang des Multiplizierers (43) mit dem Faktor (c-1) an einen zweiten Eingang (47) des zweiten Addierers (45) angeschlossen ist.

5. Filter nach einem beliebigen der vorhergehenden Ansprüche, dadurch gekennzeichnet, dass für eine Abtastfrequenz in der Grössenordnung von 4286 kHz der Koeffizient (b/a) den Wert −0,685 und der Koeffizient (d/c) den Wert −0,8827 hat.

6. Fernsehempfänger, dadurch gekennzeichnet, dass er ein Filter nach einem beliebigen der Ansprüche 1 bis 5 enthält.

# FIG_1

# FIG_2

0 059 133

# FIG_3

# FIG_4

9